# EUROPEAN PATENT SPECIFICATION

(11) **EP 2 479 796 B1**
(45) Date of publication and mention of the grant of the patent: **27.08.2014**
(21) Application number: 10817254.5
(22) Date of filing: 16.09.2010
(51) Int. Cl.: H01L 31/04, H01L 31/0224, H01L 31/068

(54) **SOLAR BATTERY, SOLAR BATTERY MODULE, AND SOLAR BATTERY SYSTEM**
SOLARBATTERIE, SOLARBATTERIEMODUL UND SOLARBATTERIESYSTEM
BATTERIE SOLAIRE, MODULE DE BATTERIE SOLAIRE, ET SYSTÈME DE BATTERIE SOLAIRE

(30) Priority: 18.09.2009 JP 2009216298
(43) Date of publication of application: 25.07.2012
(73) Proprietor: Sanyo Electric Co., Ltd., Osaka 570-8677 (JP)
(72) Inventor: FUJISHIMA Daisuke, Moriguchi-shi Osaka 570-8677 (JP); NAKAMURA Yuya, Moriguchi-shi Osaka 570-8677 (JP); TOKUOKA Nozomu, Moriguchi-shi Osaka 570-8677 (JP); KINOSHITA Toshihiro, Moriguchi-shi Osaka 570-8677 (JP)
(74) Representative: Calderbank, Thomas Roger
(86) International application number: PCT/JP2010/066072
(87) International publication number: WO 2011/034141

(56) References cited:
- EP-A1- 2 261 995
- EP-A1- 2 479 763
- EP-A2- 1 881 534
- WO-A1-2008/146693
- WO-A1-2008/146693
- WO-A1-2009/116580
- JP-A- 3 043 911
- JP-A- 2001 047 549
- JP-A- 2002 231 054
- JP-A- 2005 064 273
- JP-A- 2005 064 273
- JP-A- 2005 108 468
- JP-A- 2008 028 133
- KANG Y M ET AL: "Properties of Ce-doped ITO films deposited on polymer substrate by DC magnetron sputtering", THIN SOLID FILMS, ELSEVIER-SEQUOIA S.A. LAUSANNE, CH, vol. 518, no. 11, 19 August 2009 (2009-08-19), pages 3081-3084, XP026939348, ISSN: 0040-6090, DOI: 10.1016/J.TSF.2009.08.016 [retrieved on 2009-08-19]
- GRANQVIST ET AL: "Transparent conductors as solar energy materials: A panoramic review", SOLAR ENERGY MATERIALS AND SOLAR CELLS, ELSEVIER SCIENCE PUBLISHERS, AMSTERDAM, NL, vol. 91, no. 17, 15 October 2007 (2007-10-15), pages 1529-1598, XP022206195, ISSN: 0927-0248, DOI: 10.1016/J.SOLMAT.2007.04.031

## Description

### FIELD OF THE INVENTION

The claimed invention relates to a solar cell, solar cell module, and solar cell system.

### BACKGROUND OF THE INVENTION

Solar cells are expected as a new power supply of less impact on the environment because they can convert sunlight into electricity. In recent years, uses of solar cells have been widely promoted in power generating systems for general households, solar cell systems at large-scale power plants and the like, and in applications for various products. In such a situation, research and development for higher performance further promote uses of solar cells.

A solar cell system consists of, for example, one or more solar cell modules. A solar cell module may be made of a single solar cell or multiple solar cells connected in series, depending on the purposes of a solar cell system or applied products.

In some cases, an electrode for a solar cell consists of a transparent conductive film and collecting electrodes on the transparent conductive film. Preferably, such a transparent conductive film has a low resistance and is capable of large output power. For a conventional solar cell having a transparent conductive film, a transparent conductive film made from indium oxide containing tin (ITO) is known. In order to obtain higher performance of a solar cell, it is desirable to further lower the resistance and increase the solar cell output power.

A transparent conductive film is used for a liquid crystal display and the like. For example, a transparent conductive film made from indium oxide containing cerium (Ce) as an additive is disclosed. (For instance, see patent publication 1)

### PRIOR ART

### Patent publication

Patent publication 1: Patent Publication Laid-open No. Hei8-260134

### SUMMARY OF THE INVENTION

### Problems to be solved by the invention

However, when a transparent conductive film made from indium oxide containing cerium is used for a solar cell, it is difficult to obtain a good output power.

This invention considers the above-identified problems and provides a solar cell having a transparent conductive film with a good solar cell output power, a solar cell module and a solar cell system that comprise the solar cells.

### Methods to solve the problems

One aspect of the present invention is a solar cell characterized by a crystalline semiconductor substrate having a p-type or an n-type material, a p-type semiconductor layer formed on a principal surface of the substrate, and an n-type semiconductor layer formed on the other principal surface of the substrate, wherein a first transparent conductive film comprising indium oxide containing hydrogen and cerium and formed on the p-type semiconductor layer, and a second transparent conductive film comprising indium oxide containing no cerium and formed on the n-type semiconductor layer.

Another aspect of the present invention is characterized by a solar cell module that comprises any of the above-mentioned solar cells.

Yet another aspect of the present invention is a solar cell system that comprises the above-mentioned solar cell module.

### Effect of the invention

The present invention provides a solar cell having a transparent conductive film with a good solar cell output power, a solar cell module and a solar cell system that comprise the solar cells.

### BRIEF DESCRIPTION OF THE DRAWINGS

[Fig. 1] Fig. 1 (a) is a top plan view of a solar cell according to this invention. Fig. 1 (b) is a bottom plan view of the solar cell according to the present invention.
[Fig. 2] Fig. 2 (a) is a cross-sectional view of the solar cell according to the present invention, taken along lines A-A' in Fig. 1 (a) . Fig. 2 (b) is an enlarged view of vicinities of surfaces of the solar cell.
[Fig. 3] is a top plan view of a solar cell module according to the present invention.
[Fig. 4] is a perspective view of the solar cell module according to the present invention.
[Fig. 5] is a partial cross-sectional view of the solar cell module according to the present invention, taken along lines A-A' in Fig. 3.
[Fig. 6] is a diagram showing the relationship between sheet resistances and cerium (Ce) concentrations in the transparent conductive film of the solar cell according to the present invention.
[Fig. 7] is a diagram showing the relationship between output power factors and cerium (Ce) concentrations in the transparent conductive film of the solar cell.
[Fig. 8] is a table showing a composition of transparent conductive films, sheet resistances, and solar cell characteristics, of examples according to the present invention and comparative examples.
[Fig. 9] is an X-ray diffraction diagram of transparent conductive films in example 2 and comparative examples 1, 2, and 8.
[Fig. 10] is a diagram showing 2θ-diffraction angles (θ: X-ray diffraction angle) and half-widths of X-ray diffraction peak in an orientation of a (400) plane.
[Fig. 11] is a diagram showing 2θ-diffraction angles (θ: X-ray diffraction angle) and half-widths of X-ray diffraction peak in an orientation of a (440) plane.
[Fig. 12] is a diagram showing the results of a moisture resistance test in an example according to the present invention and in a comparative example.
[Fig. 13] is a table showing solar cell characteristics in the solar cell according to the present invention where the transparent conductive film formed on a n-type amorphous silicon layer includes indium oxide containing hydrogen and tungsten, and in a solar cell according to a comparative example where the transparent conductive film formed on a n-type amorphous silicon layer includes indium oxide containing hydrogen and cerium.

### EMBODIMENTS TO ENABNLE THE INVENTION

A solar cell according to an embodiment of the invention is explained below by referring to figures.

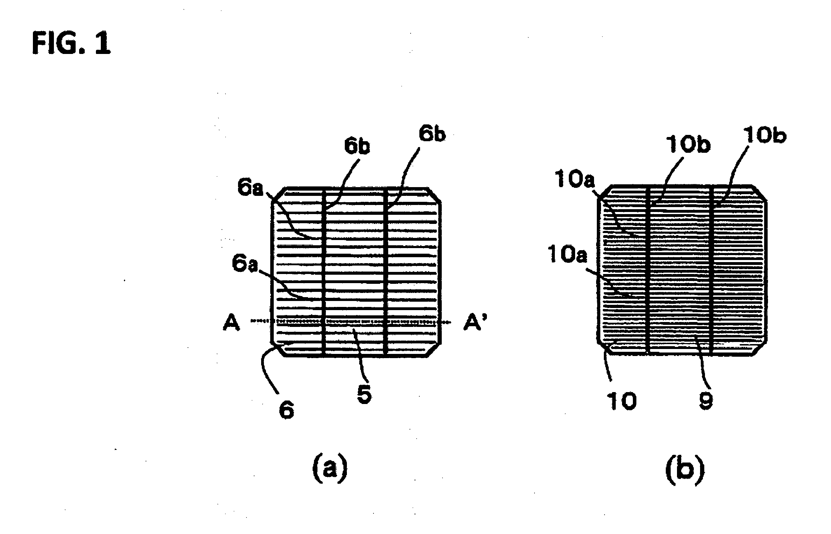

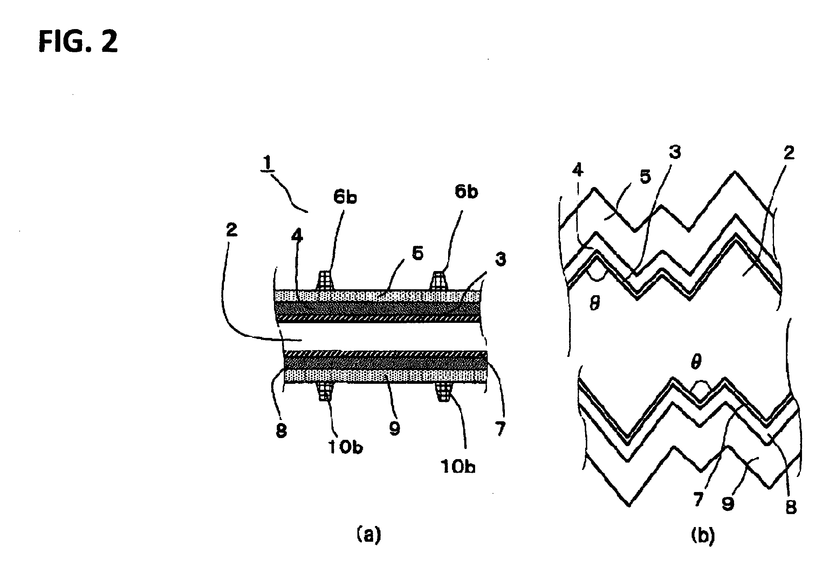

A solar cell according to an embodiment is explained below by referring to Figs. 1(a), (b), and 2. Fig. 1 (a) is a top plan view of the solar cell according to the embodiment. Fig. 1 (b) is a bottom plan view of the solar cell. Fig. 2 (a) is a cross-sectional view of the solar cell, taken along lines A-A' in Fig. 1(a). Fig. 2 (b) is an enlarged view of vicinities of surfaces of the solar cell.

Solar cell 1 is, for example, a bifacial light-receiving type solar cell. Solar cell 1 has substrate 2 including an n-type monocrystalline silicon. Substrate 2 has a resistance of approximately 1Ω · cm and a thickness of approximately 200µm. An upper surface of substrate 2 has a texture structure. Substrate 2 has substantially intrinsic i-type amorphous silicon layer 3 having a thickness of approximately 5nm, p-type amorphous silicon layer 4 having a thickness of approximately 5nm, and transparent conductive film 5 having a thickness of approximately 100nm, in this order, on an approximately entire area of the upper surface of substrate 2. Upper surface side collecting electrode 6 is further disposed on transparent conductive film 5.

The rear surface of substrate 2 also has a texture structure. Substrate 2 has substantially intrinsic i-type amorphous silicon layer 3 having a thickness of approximately 5nm, n-type amorphous silicon layer 8 having a thickness of approximately 5nm, and transparent conductive film 9 having a thickness of approximately 100nm, in this order, on an approximately entire area of a rear surface of substrate 2. Rear surface side collecting electrode 10 is further disposed on transparent conductive film 9. Solar cell 1 according to the embodiment has a so-called HIT structure having a photoelectric converter comprised of the above-identified configuration.

As shown in Fig. 2(b), the texture structure on the upper and rear surfaces of substrate 2 has concave-convex structures formed in pyramidal shapes with heights from a few to tens of micrometers (µm). The angle θ between each of the facing surfaces that form the pyramidal shapes is approximately 72°. For such a texture structure, a monocrystalline silicon substrate is used for substrate 2, for example. The texture may be formed by anisotropic etching in an orientation of the (100) plane of the monocrystalline silicon substrate.

In the embodiment, a number of pyramidal shapes are irregularly formed in such a manner that pyramidal shapes cover substantially the entire area of the surfaces of substrate 2 with the texture structure. Each of the pyramidal shapes has an irregular height (or size) and may partially overlap with neighboring pyramidal shapes. Note that peaks and valley parts of each pyramidal shape may be somewhat rounded.

Upper surface side collecting electrode 6 contains silver (Ag) as an essential ingredient and has a thickness of approximately 20 to 60µm. Upper surface side collecting electrode 6 includes finger electrodes 6a, 6a, ... and two bus bar electrodes 6b and 6b. Finger electrodes 6a, 6a, ... have multiple narrow straight line-shapes disposed parallel to each other at a predetermined interval to cover substantially the entire area of the surface of transparent conductive film 5. Bus bar electrodes 6b and 6b have strip-shapes disposed parallel to each other at a predetermined interval, and are connected to finger electrodes 6a. In the embodiment, each of finger electrode 6a, 6a, ... are disposed at approximately 2mm intervals.

Rear surface side collecting electrode 9 contains silver (Ag) as an essential ingredient and has a thickness of approximately 20 to 60µm. Rear surface side collecting electrode 10 includes finger electrodes 10a, 10a, ... and two bus bar electrodes 10b and 10b. Finger electrodes 10a, 10a, ... have multiple narrow straight line-shapes disposed parallel to each other at a predetermined interval to cover substantially the entire area of the surface of transparent conductive film 5. Bus bar electrodes 10b and 10b have strip-shapes disposed parallel to each other at a predetermined interval, and are connected to finger electrodes 10a. In the embodiment, each of finger electrode 10a, 10a, ... are disposed at approximately 1mm intervals.

In the embodiment, transparent conductive film 5 includes indium oxide as an essential ingredient and also contains hydrogen (H) and cerium (Ce). In other words, transparent conductive film 5 includes hydrogen (H), cerium (Ce), indium (In), and oxygen (O), and contains indium oxide (In₂O₃) doped with hydrogen (H) and cerium (Ce) as impurities.

Transparent conductive film 5 is formed by numerous pillar-like structures that contain substantially polycrystalline structures bristled up to fill the surface of p-type amorphous silicon layer 4. Further, transparent conductive film 5 has very little amorphous portions.

Hydrogen (H) content in transparent conductive film 5 is 1.0 x 10²¹ atoms/cm³ or higher, preferably in the order of 10²¹ atoms/cm³ or higher, and more preferably, in the order of 10²¹ atoms/cm³. Note that the amount of hydrogen content here is a value taken from transparent conductive film 5 at its intermediate region of the film in its thickness direction, and is approximately equivalent to an average content in transparent conductive film 5, except in the vicinities of its both surfaces. The concentration of hydrogen contained in transparent conductive film 5 is preferably greater in the substrate 2 side than in the upper side collecting electrode 6 side, except in the vicinities of both surfaces. And more preferably, the concentration increases gradually toward substrate 2 side.

Transparent conductive film 5 has X-ray diffraction peaks obtained in the orientation of the (400) and (440) planes. Here, the measurement is taken by measuring X-ray diffraction (XRD) from transparent conductive film 5 on the texture structure in solar cell 1. X-ray diffraction measurements as used herein refer to X-ray diffraction measurements taken from transparent conductive films on texture structures in the solar cell. (Note that X-ray diffraction measurements include measurements on texture structures that are formed before upper side collecting electrode 6 or rear side collecting electrode 10 and the like are formed.)

Transparent conductive film 5 in the orientation of the (400) plane has X-ray diffraction peaks when the 2θ-diffraction angle (θ: X-ray diffraction angle) is 35.31°-35.41°, preferably, 35.33°-35.40°, and more preferably, 35.36°-35.38°.

Transparent conductive film 5 in the orientation of the (400) plane has a half-width of X-ray diffraction peaks at 0.10°-0.30°, preferably, at 0.15°-0.25°, and more preferably, at 0.18°-0.20°.

Transparent conductive film 5 in the orientation of the (440) plane has X-ray diffraction peaks when the 2θ-diffraction angle (θ: X-ray diffraction angle) is 50.80°-50.96°, preferably, 50.85°-50.95°, and more preferably, 50.90°-50.91°.

Transparent conductive film 5 in the orientation of the (440) plane has a half-width of X-ray diffraction peaks at 0.10°-0.35°, preferably, at 0.15°-0.30°, and more preferably, at 0.17°-0.22°.

A cerium (Ce) content in transparent conductive film 5 is preferably between 1.0 x 10²⁰ atoms/cm³ or more and 1.0 x 10²¹ atoms/cm³ or less, and more preferably between 2.5 x 10²⁰ atoms/cm³ or more and 8.0 x 10²⁰ atoms/cm³ or less, and further more preferably is between 4.0 x 10²⁰ atoms/cm³ or more and 6.0 x 10²⁰ atoms/cm³ or less, and still further more preferably is between 4.5 x 10²⁰ atoms/cm³ or more, and 5.2 x 10²⁰ atoms/cm³ or less.

In the embodiment, transparent conductive film 9 includes indium oxide as an essential ingredient and contains hydrogen (H) and tungsten (W). In other words, transparent conductive film 9 includes hydrogen (H), tungsten (W), indium (In), and oxygen (O), and contains indium oxide(In₂O₃) doped with hydrogen (H) and tungsten (W) as impurities.

Transparent conductive film 9 is formed by numerous pillar-like structures that contain substantially polycrystalline structures bristled up to fill the surface of n-type amorphous silicon layer 8. Further, transparent conductive film 9 contains a very little amount of amorphous portions.

Tungsten (W) content in transparent conductive film 9 is, for example, 2.0 x 10²⁰ atoms/cm³, and hydrogen (H) content is preferably 1.0 x 10²⁰ atoms/cm³ or higher, more preferably, in the order of 10²⁰ atoms/cm³, for instance, 9.0 x 10²⁰ atoms/cm³ . Note that the amount of hydrogen content here is a value taken from transparent conductive film 9 at its intermediate region in its thickness direction, and is approximately equivalent to an average content in transparent conductive film 5, except in the vicinities of its both surfaces.

The concentration of hydrogen contained in transparent conductive film 9 is preferably greater in the substrate 2 side of the film than in the rear side collecting electrode 10 side of the film, except in the vicinities of both surfaces of transparent conductive film 9. And more preferably, the concentration increases gradually toward the substrate 2 side.

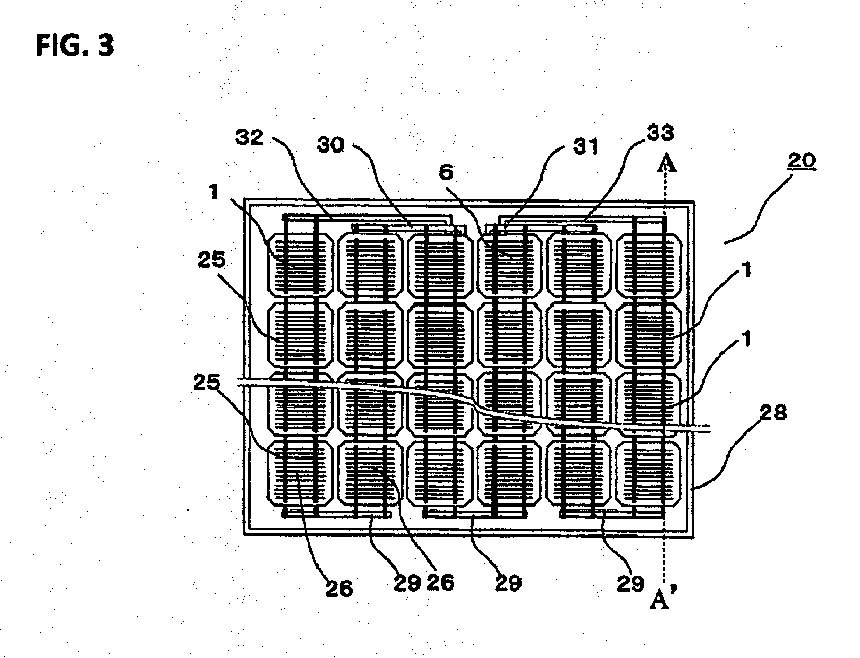

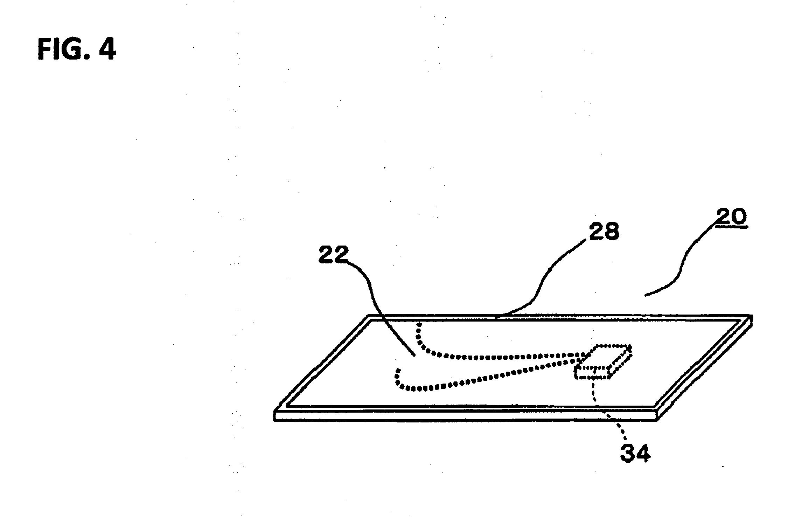

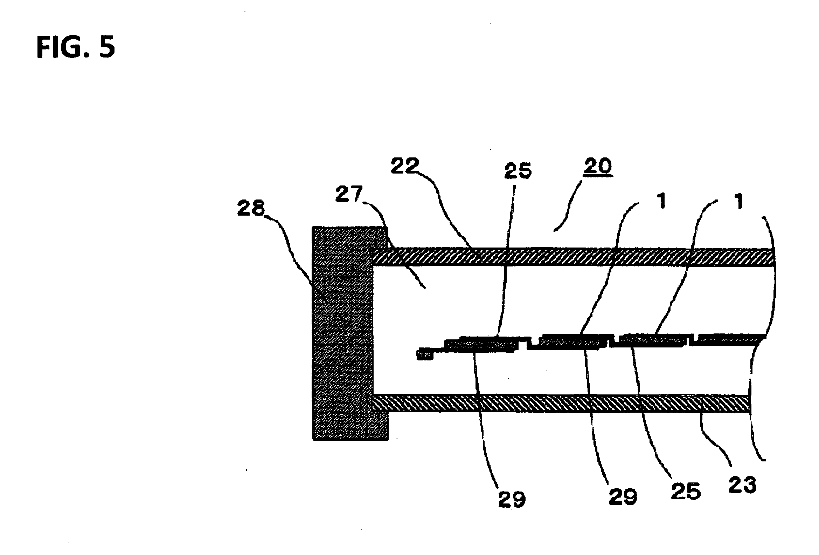

Hereinafter, a solar cell module having solar cells according to the embodiment is explained by referring to Figs. 3 and 5. Fig. 3 is a top plan view of the solar cell module according to the embodiment. Fig. 4 is a perspective view of the solar cell module. Fig. 5 is a partial cross-sectional view of the solar module cell taken along lines A-A' in Fig. 3.

20 is a solar cell module having solar cells 1 according to this invention. Solar cell module 20 includes transparent upper surface side cover 22 made from hardened glass and the like, and weather resistant rear surface side cover 23 that contains resin film made from polyethylene terephthalate resin (PET) and the like. Arrays of solar cells 26, 26, ... are disposed in straight lines in between upper surface side cover 22 and rear surface side cover 23 via filling material 27 such as ethylene-vinyl acetate (EVA). Solar cell array 26 includes multiple solar cells 1, 1, ... and each of neighboring solar cells is connected in series by strips (or belt) of first conductive connecting members 25. First connecting member 25 includes copper flat wires, the surface of which is coated with a conductive surface material such as Sn-Ag-Cu or a solder layer (soft layer) such as Sn-Pb. Frame 28 is attached around a board-like structure defined by upper surface side cover 22 and rear surface side cover 23 to support the structure. Frame 28 is made of metal that includes aluminum and the like. A terminal box that draws output power of the solar cell is attached on rear surface side cover 23.

Solar cell arrays 26, 26, ... are disposed in parallel to each other and all solar cell arrays 26, 26, ... are electrically connected in series according to the embodiment. Connecting members 25, 25, 25, 25, at one end sides of neighboring solar cell arrays 26, 26, are soldered to second connecting member 29 that is a conductive strip, such as a copper flat wire coated with a solder layer. Connecting members 25, 25, 25, 25, of neighboring solar cell arrays 26, 26, at the other end sides are soldered to third connecting members 30 and 31 that are conductive L-shapes made of copper flat wires or the like, coated with a solder layer. With the above-mentioned configuration, multiple solar cells 1, 1, ... of solar cell module 20 are arranged in a matrix.

Each of L-shaped connecting members 32, 33 (i.e., connecting members to draw output power) is connected by solder to connecting members 25, 25, ... of solar cells 1, 1 disposed at the both endmost positions in power drawing sides in each of outermost solar cell arrays 26, 26. L-shaped connecting members 32, 33 include copper flat wires and the like coated with a solder layer.

Note that an insulating member (not indicated in the figures), such as an insulating sheet like polyethylene terephthalate(PET), is disposed at a crossing part between L-shaped connecting members 30, 31 and L-shaped connecting members 32, 33, and a crossing part between L-shaped connecting member 31 and L-shaped connecting member 33.

Although not shown in figures, each of the endmost portions of L-shaped connecting member 30, L-shaped connecting member 31, L-shaped connecting member 32, and L-shaped connecting member 33 is lead into terminal box 34 located at the center of the upper side of the rear surface of solar cell module 20, via a notch (not shown) in rear surface side cover 23. Between L-shaped connecting member 32 and L-shaped connecting member 30, and between L-shaped connecting member 30 and L-shaped connecting member 31, and between L-shaped connecting member 31 and L-shaped connecting member 33 are each connected with a bypass diode (not shown) in terminal box 34.

A solar cell system according to the embodiment is, for example, a solar cell system comprised of multiple solar cell modules 20 each fixed on a roof surface of a private residence with fixing screws. Each of neighboring solar cell modules 20 are connected and laid out from a lower side (eave side) to an upper side (ridge side) in a terraced pattern (stair case pattern).

Hereinafter, a method of manufacturing a solar cell according to the embodiment is explained.

First, an n-type monocrystalline silicon substrate whose upper surface has an orientation of the (100) plane is washed so that impurities are removed. Then, upper and rear surfaces of the monocrystalline silicon substrate are etched anisotropically with an etching liquid containing an NaOH aqueous solution. In this way, substrate 1 having a texture structure formed on its upper and rear surfaces is prepared.

Next, i-type amorphous silicon layer 3 and p-type amorphous silicon layer 4 are formed in this order by using an RF plasma CVD method, for example, on the upper surface of n-type monocrystalline silicon substrate 2 where the texture structure is formed. The conditions for the RF plasma CVD method may be at a frequency of about 13.56 MHz, a formation temperature of approximately 100°C - 300°C, a reaction pressure of about 5Pa - 100Pa, and an RF power of about 1mW/cm²-500mW/cm². Further, i-type amorphous silicon layer 7 and n-type amorphous silicon layer 8 are formed in this order on the rear surface of substrate 2 where a texture structure is formed.

Next, transparent conductive film 5 including indium oxide containing hydrogen (H) and cerium (Ce) as impurities is formed on p-type amorphous silicon layer 4 by using the ion plating method in an atmosphere of Ar/O₂ gas mixture and steam at a room temperature. As an ingredient for forming the film, a sintered body of In₂O₃ powder that contains a predetermined amount of cerium oxide (CeO₂) powder as a dopant is used. In this case, the amount of cerium (Ce) contained in transparent conductive film 5 can be changed by using the sintered body where the content of cerium oxide (CeO₂) powder is changed.

Then, transparent conductive film 9 including indium oxide containing hydrogen (H) and tungsten (W) as impurities is formed on n-type amorphous silicon layer 8 by using the ion plating method in an atmosphere of Ar/O₂ gas mixture and steam at a room temperature. As an ingredient for forming the film, a sintered body of In₂O₃ powder that contains a predetermined amount of tungsten oxide (WO₃) as a dopant is used.

Note that according to the manufacturing method of the embodiment, crystallization of transparent conductive films 5, 9 is preferably proceeded by annealing at approximately 200°C for 1 hour. In the embodiment, the heating treatment for forming the electrodes described below combines with the annealing treatment. In such a case, and in other cases where the annealing process is combined, a separate annealing process may not be required.

Next, a silver paste prepared by kneading fine silver (Ag) powder into a thermosetting resin, such as an epoxy resin, is formed into a predetermined shape on a predetermined region on transparent conductive film 5 by using the screen printing method. Also, a silver paste prepared by kneading fine silver (Ag) powder into a thermosetting resin, such as an epoxy resin, is formed into a predetermined shape on a predetermined region on transparent conductive film 9 by the using the screen printing method. The respective silver pastes are cured by heating at approximately 200°C for 1 hour. Thus, upper side collecting electrode 6 and rear side collecting electrode 10 are formed. As described above, solar cell 1 according to the embodiment is formed in this manner.

Next, one of solar cell 1 is connected to another solar cell 1 in adjacent solar cells 1, 1 by connecting members 25, 25, ... that are disposed to face bus bar electrodes 6b, 6b of upper side collecting electrode 6 of one of solar cell 1, and also to face bus bar electrodes 10b, 10b of rear side collecting electrode 10 of another solar cell 1 via a solder or an adhesive agent containing a thermosetting resin. Then, by heating up and cooling down while a pressure is applied in this state, each connecting member 25, 25, ... is fixed and connected on respective bus bars 6b, 10b, thus forming an array of solar cells 26. Note that in case the adhesive agent containing thermosetting resin is used, an adhesive agent including a thermosetting resin containing a conductive filler may be used.

Next, multiple solar cell arrays 26 are prepared. Then, after making an structural body where connecting members 29, 29, 29, and connecting members 30, 31, 32, 33 are attached, upper side cover 22, a sealing sheet that becomes a filling material, the structural body, a sealing sheet that becomes a filling material, and rear surface side cover 23, are layered in this order and pressed at approximately 150°C for about 10 minutes in a vacuum. Thereafter, the filling materials are completely cured by heating at approximately 150°C for 1 hour. Lastly, solar cell module 20 is completed by attaching terminal box 34 and frame 28.

In the embodiment, because transparent conductive film 5 contains hydrogen (H) within a range of a predetermined amount as well as indium oxide including cerium (Ce) within a predetermined amount range, transparent conductive film 5 has a low resistance and is capable of increasing the output power of solar cell 1.

Especially, because 2θ-diffraction angles (θ: x ray diffraction angle) at the X-ray diffraction peak as well as the half-width are both in preferable ranges in the orientation of the (400) plane in transparent conductive film 5, transparent conductive film 5 has a lower resistance and the output power of solar cell 1 can be even higher.

Further, because 2θ-diffraction angles (θ: x ray diffraction angle) at the X-ray diffraction peak as well as the half-width are both in preferable ranges in the orientation of the (440) plane in transparent conductive film 5, transparent conductive film 5 has a lower resistance and the output power of solar cell 1 can be even higher.

As described above, because transparent conductive film 5 has a low resistance, it is possible to improve the output power of solar cell 1 while reducing the area of upper surface side collecting electrode 6. As a result, the amount of materials used for upper surface side collecting electrode 6 can be reduced and thus can lower the manufacturing cost.

From the measurement results of electron backscatter diffraction (EBSD), transmission electron microscopy (TEM), and X-ray diffraction (XRD), transparent conductive films 5, 9 according to the embodiment are found to include pillar-like structures that contain substantially polycrystalline structures, and a very little amount of amorphous portions. X-ray diffraction peaks in cerium oxide and tungsten oxide cannot be observed from the X-ray diffraction measurements of transparent conductive films 5, 9.

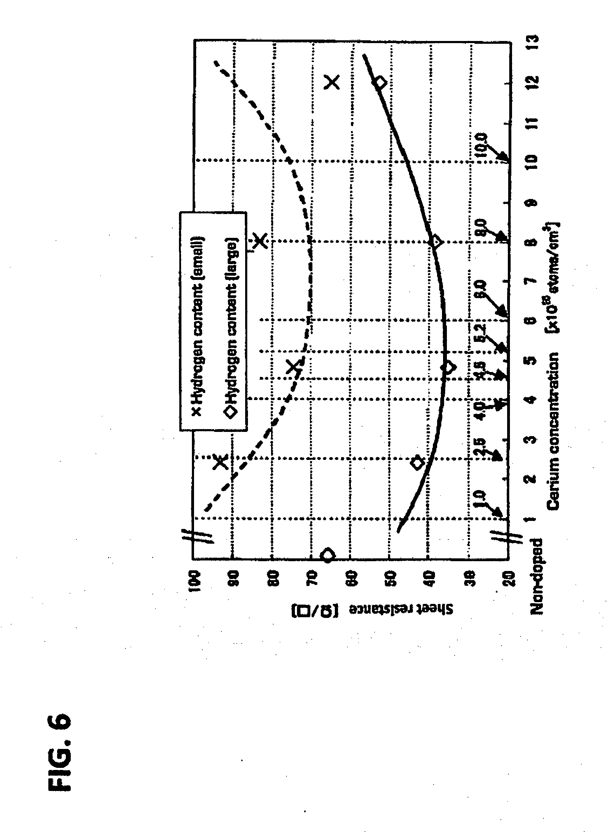

Fig. 6 is a diagram showing the relationship between sheet resistances and cerium (Ce) concentrations in transparent conductive film 5 of the solar cell. In the figure, the solid line indicates that the hydrogen (H) content in transparent conductive film 5 is 2.0 x 10²¹ atoms/cm³, and the broken line indicates that the hydrogen (H) content in transparent conductive film 5 is smaller than the order of 10²¹ atoms/cm³ (i.e., a hydrogen content of 9.0 x 10²⁰ atoms/cm³ is used). Note that sheet resistance is measured by the four-terminal sensing method. The amount of Ce is measured by the Rutherford backscattering spectrometry (RBS) method. The amount of hydrogen is measured by the hydrogen forward scattering (HFS) method.

Fig. 6 shows that the resistance in transparent conductive film 5 is lower when the hydrogen (H) content is in the order of 10²¹ atoms/cm³ than when in the order of 10²⁰ atoms/cm³.

In addition, when the hydrogen (H) content is in the order of 10²¹ atoms/cm³, the cerium (Ce) content is desirably between 1.0 x 10²⁰ atoms/cm³ or greater and 1.0 x 10²¹ atoms/cm³ or less, preferably between 2.5 x 10²⁰ atoms/cm³ or greater and 8.0 x 10²⁰ atoms/cm³ or less, more preferably between 4.0 x 10²⁰ atoms/cm³ or greater and 6.0 x 10²⁰ atoms/cm³ or less, and even more preferably between 4.5 x 10²⁰ atoms/cm³ or greater and 5.2 x 10²⁰ atoms/cm³ or less.

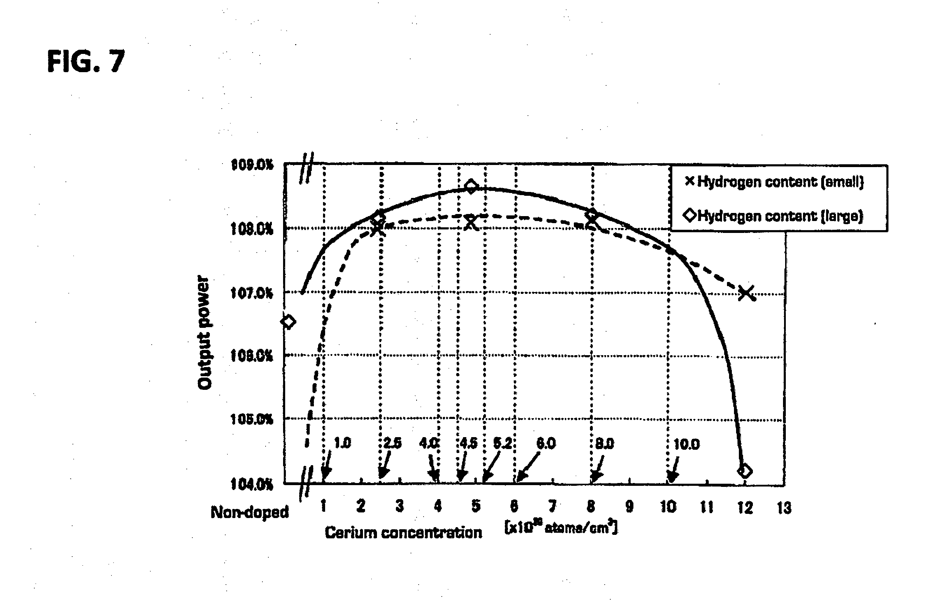

Fig. 7 is a diagram showing the relationship between output power factors and cerium (Ce) concentrations in transparent conductive film 5 of the solar cell. Each solar cell here is the same one as used in Fig. 6. The solid line in the figure indicates that the hydrogen (H) content in transparent conductive film 5 is 2.0 x 10²¹ atoms/cm³, and the broken line indicates that the hydrogen (H) content in transparent conductive film 5 is smaller than the order of 10²¹ atoms/cm³ (i.e., the hydrogen content of 9.0 x 10²¹ atoms/cm³ is used.) Note that a solar simulator is used for measuring the output power of solar cells. The measurement is taken under conditions of a 1.5 air mass (AM) and a 100mW/cm² light intensity. The standard output value is taken from a solar cell using an indium oxide film containing in the order of 10²⁰ atoms/cm³ of hydrogen (H) and no cerium (Ce), as a corresponding transparent conductive film to transparent conductive film 5.

Fig. 7 shows that when the cerium (Ce) content in transparent conductive film 5 in a solar cell is between 1.0 x 10²⁰ atoms/cm³ or greater and 1.2 x 10²¹ atoms/cm³ or less, and hydrogen (H) content is in the order of 10²⁰ - 10²¹ atoms/cm³, the output power is greater than that of the solar cell with a transparent conductive film including indium oxide but no cerium.

Fig. 7 also indicates that when the hydrogen (H) content is in the order of 10²¹ atoms/cm³, the amount of cerium (Ce) in transparent conductive film 5 is desirably between 1.0 x 10²⁰ atoms/cm³ or greater and 1.0 x 10²¹ atoms/cm³ or less, preferably between 2.5 x 10²⁰ atoms/cm³ or greater and 8.0 x 10²⁰ atoms/cm³ or less, more preferably between 4.0 x 10²⁰ atoms/cm³ or greater and 6.0 x 10²⁰ atoms/cm³ or less, and even more preferably between 4.5 x 10²⁰ atoms/cm³ or greater and 5.2 x 10²⁰ atoms/cm³ or less.

Although not shown in Figs. 6 and 7, when hydrogen (H) content in transparent conductive film 5 is, for example, 3.1 x 10²¹ atoms/cm³ and the cerium (Ce) content is 7.0 x 10²⁰ atoms/cm³, the sheet resistance is less than 50 Ω/□ and the obtained output power is as high as 108.1% of the above-mentioned standardized output power.

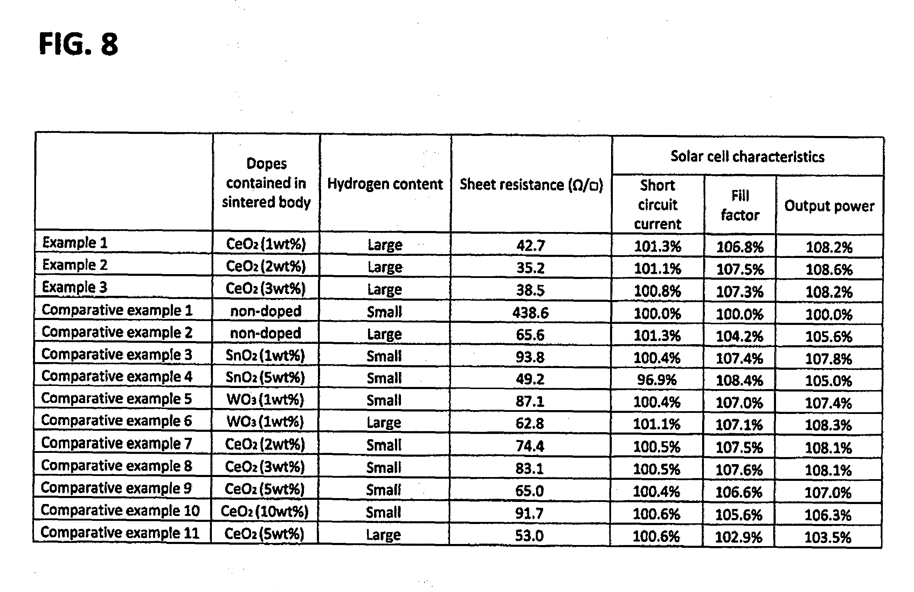

Fig. 8 is a table showing compositions of each transparent conductive film, sheet resistances of each transparent conductive film, and solar cell characteristics, of examples 1-3 according to the embodiment and comparative examples 1-11 having alternative transparent conductive films. Note that in the figure, the column for "dopants contained in sintered body" indicates impurities within a sintered body including indium oxide used for making transparent conductive films and with the mass percentage of impurities in parentheses. The indication of "large" in the column for "hydrogen content" refers to the content of hydrogen in a transparent conductive film being 2.0 x 10²¹ atoms/cm³ and the indication of "small" refers to the content of hydrogen being 9.0 x 10²⁰ atoms/cm³.

Solar cells used in examples 1-3 here are the same as that of the embodiment as used in Figs. 6 and 7. The cerium (Ce) content in transparent conductive film 5 used in examples 1 - 3 are 2.4 x 10²⁰ atoms/cm³, 4.8 x 10²⁰ atoms/cm³ and 8.0 x 10²⁰ atoms/cm³, respectively. The composition in comparative examples 1-3 is the same as the embodiment except for the contents of transparent conductive film 5.

Fig. 8 indicates that some of the comparative examples exhibit either a good sheet resistance or a good solar cell output power, however, both features are not good in a single comparative example. In contrast, examples 1-3 that have transparent conductive film 5 of indium oxide containing cerium and hydrogen in the order of 10²¹ atoms/cm³ exhibit good in both sheet resistance and solar cell output power.

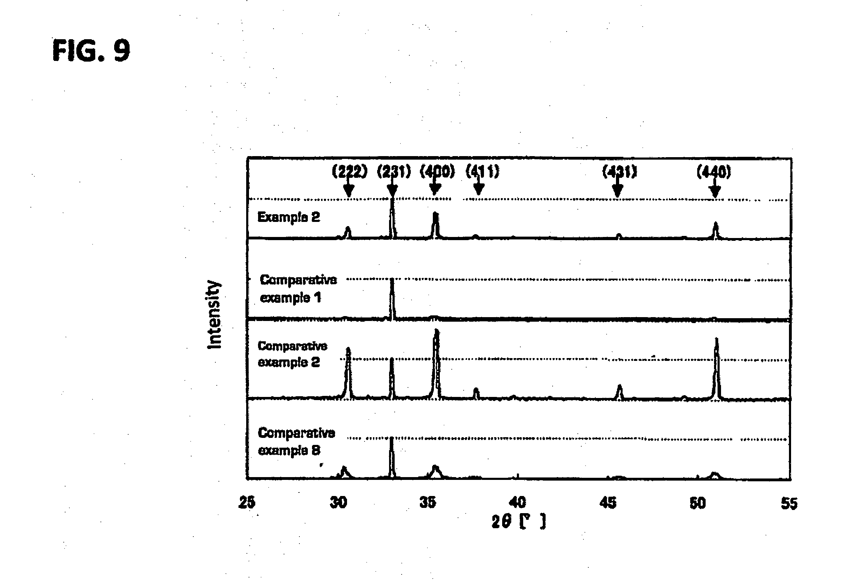

Fig. 9 is an X-ray diffraction pattern diagram of example 2 and comparative examples 1, 2, and 8. The vertical axis indicates the intensity of X-ray diffraction, and the horizontal axis indicates 2θ-diffraction angles (where θ is an X-ray diffraction angle). Note that the X-ray diffraction measurements are taken from the transparent conductive films formed on the texture structure on solar cell 1, before upper side collecting electrode 6 and rear side collecting electrode 10 are formed. Transparent conductive films used here are annealed at approximately 200°C for 1 hour. Note that the measurements of 2θ are taken every 0.002°.

Fig. 9 indicates that measurement in example 2 differs greatly from that of comparative examples 1, 2, and 8.

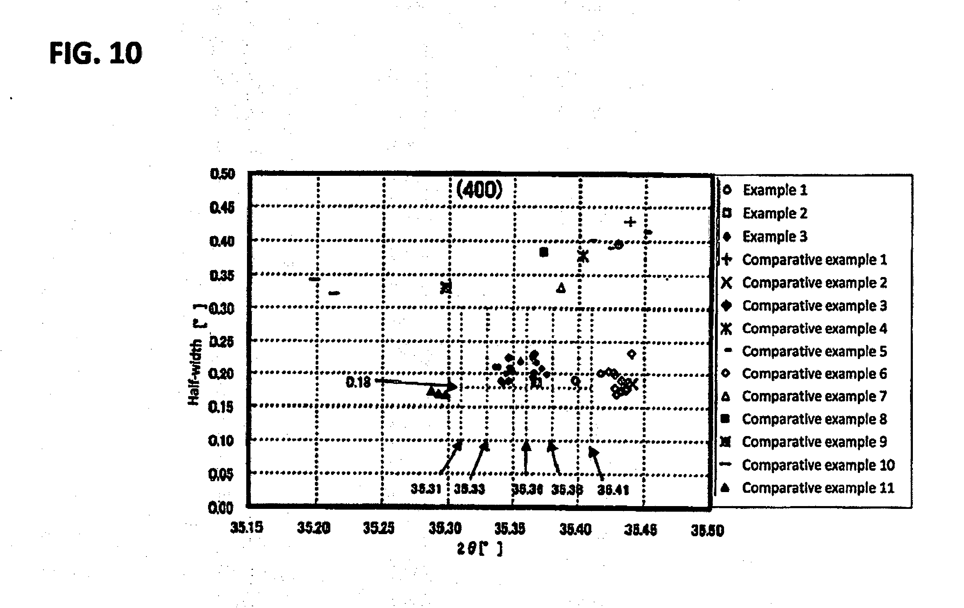

Fig. 10 is a diagram showing 2θ-diffraction angles (θ: X-ray diffraction angle) and half-widths of X-ray diffraction peak of transparent conductive film 5 in the orientation of the (400) plane in solar cells of examples 1-3, and 2θ-diffraction angles (θ: X-ray diffraction angle) and half-width of X-ray diffraction peak of transparent conductive films in the orientation of the

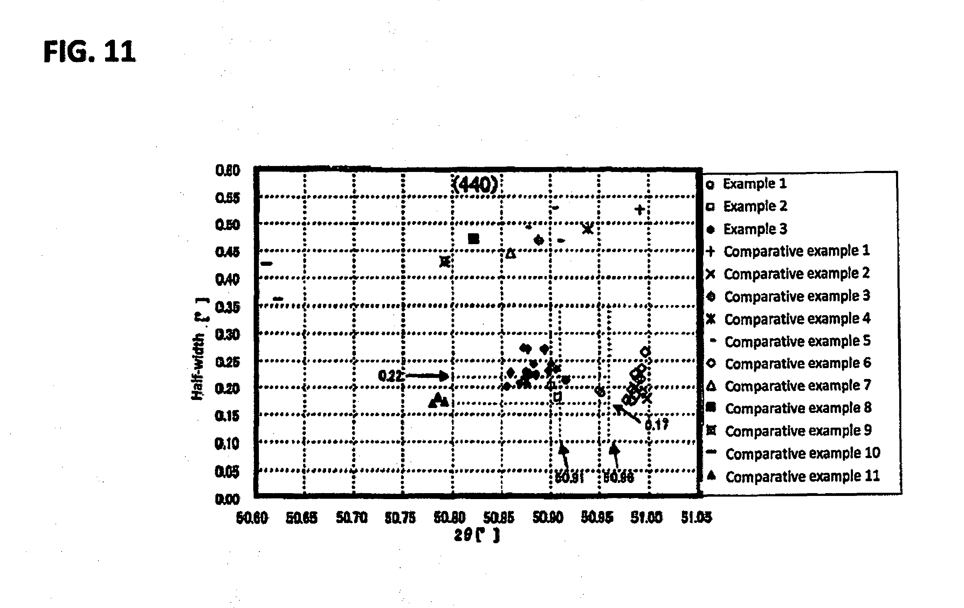

(400) plane in comparative examples 1-11, corresponding to transparent conductive film 5. Fig. 11 is a diagram showing 2θ-diffraction angles (θ: X-ray diffraction angle) and half-widths of X-ray diffraction peak of transparent conductive film 5 in the orientation of the (440) plane in solar cells of examples 1-3, and 2θ-diffraction angles (θ: X-ray diffraction angle) and half-width of X-ray diffraction peak of transparent conductive films in the orientation of the (440) plane in comparative examples 1-11, corresponding to transparent conductive film 5.

Note that the X-ray diffraction measurements are taken from the transparent conductive films on the texture structure on solar cell 1 before upper surface side collecting electrode 6 and rear side collecting electrode 10 are formed. Transparent conductive films used here are annealed at approximately 200°C for 1 hour. Note that the measurements of 2 θ are taken every 0.002°.

Fig.10 indicates that the X-ray diffraction peak obtained in the orientation of the (400) plane of transparent conductive film 5 is observed when 2θ-diffraction angle (θ: X-ray diffraction angle)is 35.31°-35.41°, preferably, 35.33°-35.40°, and more preferably, 35.36°-35.38°. Further, the half-width of the X-ray diffraction peak in the orientation of the (400) plane of transparent conductive film 5 is 0.10°-0.30°, preferably, 0.15°-0.25°, and more preferably, 0.18°-0.20°.

Fig.11 indicates that the X-ray diffraction peak in the orientation of the (440) plane of transparent conductive film 5 is observed when 2θ-diffraction angle (θ: X-ray diffraction angle) is 50.80°-50.96°, preferably, 50.85°-50.95°, and more preferably, 50.90°-50.91°. Further, the half-width of the X-ray diffraction peak in the orientation of the (440) plane of transparent conductive film 5 is 0.10°-0.35°, preferably, 0.15°-0.30°, and more preferably, 0.17°-0.22°.

Figs. 10 and 11 indicate that in terms of 2θ-diffraction angles (θ: X-ray diffraction angle) and half-width of X-ray diffraction peaks obtained in orientations of the (400) plane and the (440) plane, transparent conductive film 5 formed on p-type amorphous silicon layer 4 that includes indium oxide containing cerium (Ce) and hydrogen (H) of in the order of 10²¹ atoms/cm³ according to the embodiment having a low sheet resistance and a preferable solar cell output power, shows quite different results from those of transparent conductive films that include indium oxide containing cerium but the hydrogen content is less than the order of 10²⁰ atoms/cm³, and from those of transparent conductive films that include indium oxide containing tungsten, or indium oxide containing tungsten and hydrogen, or indium oxide containing ITO and hydrogen.

The result indicates that shapes and sizes of crystalline particles and pillar-like structures in transparent conductive films that include indium oxide containing cerium and hydrogen in the order of 10²¹ atoms/cm³ are different from those in transparent conductive films that include indium oxide containing cerium but the hydrogen content is in the order of 10²⁰ atoms/cm³ or less. It is not clear why transparent conductive film 5 exhibits a lower resistance and a higher solar cell output power when the transparent conductive film includes indium oxide containing cerium and hydrogen of the order of 10²¹ atoms/cm³. However, it is highly possible that the shapes and sizes of crystalline particles and pillar-like structures specified by the above-mentioned x-ray diffraction are greatly contributing to the superior characteristics.

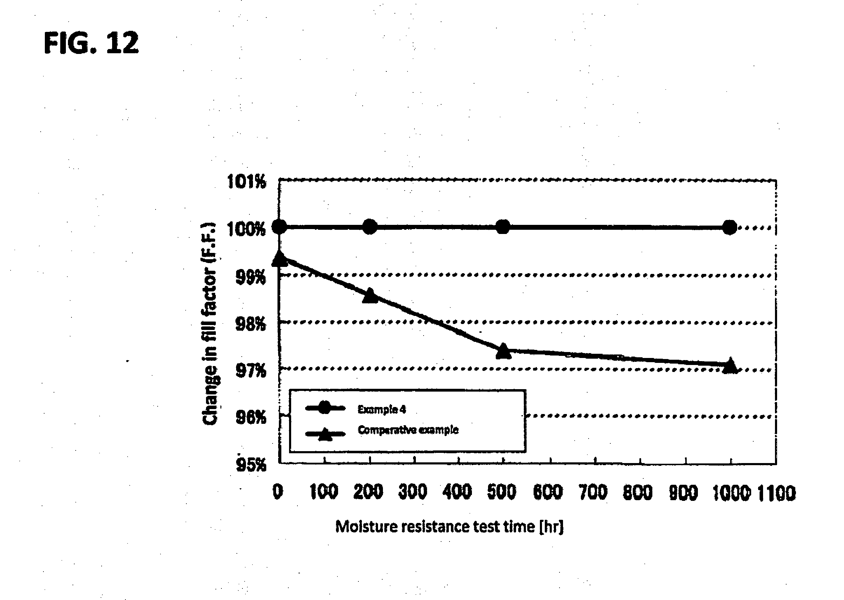

Fig. 12 is a diagram showing a result of acceleration tests of moisture resistance of solar cells in example 4 according to the embodiment and in a comparative example. The vertical axis indicates comparative values of fill factor (F.F.) in the comparative example, where the fill factor of the solar cell in example 4 is standardized as a 100% at a respective time. The horizontal axis indicates the time of the moisture resistance experiment. Acceleration tests are carried out under conditions of a humidity of 85% and a temperature at 85°C. Note that the fill factor in example 4 is higher than that in the comparative example at the beginning of the experiment.

In the experiment, transparent conductive film 5 in solar cell 1 in example 4 formed on p-type amorphous silicon layer 4 includes indium oxide containing 3.1 x 10²¹ atoms/cm³ of hydrogen (H) and 7.0 x 10²⁰ atoms/cm³ of cerium (Ce). For the comparative example, a solar cell with a transparent conductive film that includes indium oxide containing no cerium but containing 3.4 x 10²¹ atoms/cm³ of hydrogen (H) and 2.0 x 10²⁰ atoms/cm³ of tungsten (W) is used as a substitute for transparent conductive film 5. Note that a transparent conductive film on n-type amorphous silicon layer 8 used both in example 4 and the comparative example includes indium oxide containing hydrogen of 3.1 x 10²¹ atoms/cm³ and tungsten (W) of 6.0 x 10²⁰ atoms/cm³.

Fig. 12 indicates that the solar cell in the embodiment whose transparent conductive film 5 on p-type amorphous silicon layer 4 located in n-i-p bonding side includes indium oxide containing hydrogen (H) and cerium (Ce) exhibits a superior moisture resistance to the solar cell in the comparative example whose transparent conductive film includes indium oxide containing hydrogen (H) and tungsten (W) but containing no cerium (Ce).

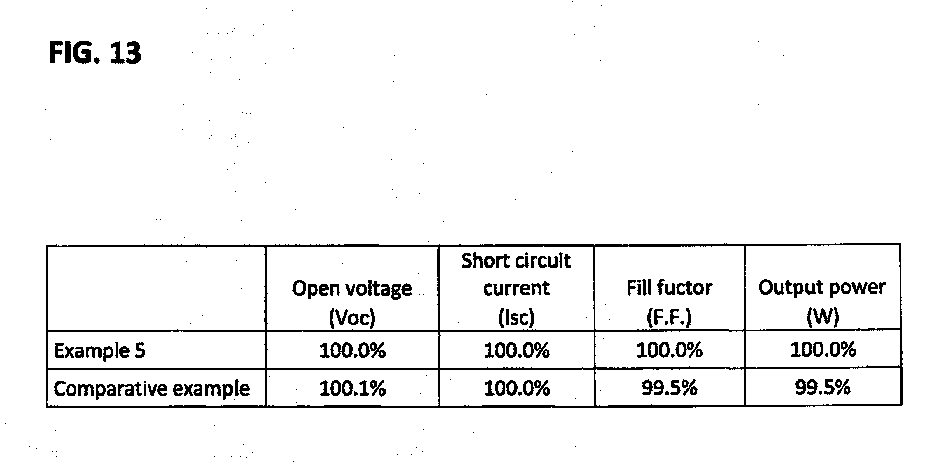

Fig. 13 is a table showing solar cell characteristics in solar cell 1 in example 5 according to the embodiment where transparent conductive film 9 formed on n-type amorphous silicon layer 8 includes indium oxide containing hydrogen (H) and tungsten (W), and in a solar cell according to a comparative example where a transparent conductive film formed on n-type amorphous silicon layer 8 includes indium oxide containing hydrogen (H) and cerium (Ce). Note that transparent conductive film 5 in example 5 includes indium oxide containing hydrogen of 3.1 x 10²¹ atoms/cm³ and cerium (Ce) of 7.0 x 10²⁰ atoms/cm³, and transparent conductive film 9 in example 5 includes indium oxide containing hydrogen of 3.1 x 10²¹ atoms/cm³ and tungsten (W) of 6.0 x 10²⁰ atoms/cm³. A transparent conductive film corresponding to transparent conductive film 5 in the comparative example includes indium oxide containing hydrogen of 3.1 x 10²¹ atoms/cm³ and cerium (Ce) of 7.0 x 10²⁰ atoms/cm³, and the transparent conductive film corresponding to transparent conductive film 9 in the comparative example includes indium oxide containing hydrogen of 3.1 x 10²¹ atoms/cm³ and cerium (Ce) of 7.0 x 10²⁰ atoms/cm³.

Fig. 13 indicates that the transparent conductive film that includes indium oxide containing cerium (Ce) and a large content of hydrogen (H) is preferable when formed on the p-type amorphous silicon layer, rather than on the n-type amorphous silicon layer.

For transparent conductive films on n-type amorphous silicon layer, a transparent conductive film that includes indium oxide containing a little amount of hydrogen in the order of 10²⁰ atoms/cm³ and tungsten (W) may be preferable as mentioned above. However, a transparent conductive film that includes indium oxide containing a little amount of hydrogen in the order of 10²⁰ atoms/cm³ and cerium (Ce) may be also used.

Also as shown in Fig. 13, a transparent conductive film containing a large content of hydrogen (H) in the order of 10²¹ atoms/cm³ and tungsten (W) (that is different from the transparent conductive film including indium oxide containing a large content of hydrogen and cerium) may be used for the transparent conductive film on the n-type amorphous silicon layer.

In the instant case, because the transparent conductive film used on the p-type amorphous silicon layer contains a high content of hydrogen in the order of 10²¹ atoms/cm³, it is preferable to use the transparent conductive film including indium oxide containing tungsten (W) and a high content of hydrogen that is 1.0 x 10²¹ atoms/cm³ or more, and even more preferably in the order of 10²¹ atoms/cm³ on the n-type amorphous silicon layer, for a less complicated manufacturing procedure.

The above-mentioned solar cells according to the embodiment are explained referring to so-called HIT solar cells. However, the embodiment can be conveniently applied to various kinds of solar cells such as monocrystalline solar cells and polycrystalline solar cells. Also, the embodiment can be applied to bifacial light-receiving type solar cells and monofacial light-receiving type solar cells.

In the embodiments explained above, the embodiments have two upper surface side collecting electrodes and two rear surface side collecting electrodes; however, the number, the shape, etc. of the electrodes may be changed accordingly.

Upper surface side collecting electrode and/or rear surface side collecting electrode may have a busbarless structure, in which no bus bar is formed.

In the above-mentioned embodiment, the p-type silicon layer is disposed at a major incident light receiving side, however, an n-type silicon layer may be disposed instead. In such a case, it is preferable to change the pitch, etc. of the finger electrodes of the collecting electrodes.

Further, the solar cell module according to the embodiment is not limited to the above-embodiments. The module may not have a frame, for example. Also, the solar cell modules may be used for applied products.

The solar cell module according to the embodiment may be used for bifacial light-receiving type solar cell modules, and both the upper surface side cover and the rear surface side cover may be glass plates.

The solar cell system according to the embodiment is explained, for example, for residential households. However, the embodiment is not limited to this application, and layout methods of solar cell modules may be flexibly changed.

### POTENTIAL USE IN THE INDUSTRY

As described above, the embodiment can be used in the field of photovoltaic power generation and the like, because the embodiment can provide a solar cell that produces a good output power, and a solar cell module and a solar cell system including the solar cells.

### EXPLANATION OF REFERENCE NUMBER

- 1: Solar cell
- 2: n-type monocrystalline silicon substrate
- 3: i-type amorphous silicon layer
- 4: p-type amorphous silicon layer
- 5: Transparent conductive layer
- 7: i-type amorphous silicon layer
- 8: n-type amorphous silicon layer
- 9: Transparent conductive layer
- 20: Solar cell module

## Claims

1. A solar cell **characterized by**
a crystalline semiconductor substrate comprising a p-type or an n-type material;
a p-type semiconductor layer (4) formed on a principal surface of the substrate; and
an n-type semiconductor layer (8) formed on the other principal surface of the substrate;
wherein a first transparent conductive film (5) comprising indium oxide containing hydrogen and cerium and formed on the p-type semiconductor layer; and
a second transparent conductive film (9) comprising indium oxide, containing no cerium and formed on the n-type semiconductor layer.

2. The solar cell according to claim 1, **characterized in that** the second transparent conductive film (9) contains hydrogen and tungsten.

3. The solar cell according to claim 1, **characterized in that** the hydrogen content is in the order of 10²¹ atoms/cm³ in the first and the second transparent conductive films.

4. The solar cell according to claim 1, **characterized in that**
the substrate comprises monocrystalline silicon, wherein the principal surface and the other principal surfaces are textured, and further wherein
the p-type semiconductor layer (4) comprises a p-type amorphous silicon layer and the n-type semiconductor layer (8) comprises an n-type amorphous silicon layer.

5. A solar cell module **characterized by** having one or more solar cells according to any one of claims 1-4.

6. A solar cell system **characterized by** having one or more solar cell modules according to claim 5.

## Patentansprüche

1. Solarzelle, **gekennzeichnet durch**:
ein kristallines Halbleitersubstrat, das ein p-Typ- oder ein n-Typ-Material umfasst;
eine p-Typ-Halbleiterschicht (4), die auf einer Hauptfläche des Substrats ausgebildet ist; und
eine n-Typ-Halbleiterschicht (8), die auf der anderen Hauptfläche des Substrats ausgebildet ist;
wobei ein erster transparenter leitfähiger Film (5) Wasserstoff- und Ceriumhaltiges Indiumoxid umfasst und auf der p-Typ-Halbleiterschicht ausgebildet ist; und wobei
ein zweiter transparenter leitfähiger Film (9) Indiumoxid umfasst, das kein Cerium enthält, und auf der n-Typ-Halbleiterschicht ausgebildet ist.

2. Solarzelle nach Anspruch 1, **dadurch gekennzeichnet, dass** der zweite transparente leitfähige Film (9) Wasserstoff und Wolfram umfasst.

3. Solarzelle nach Anspruch 1, **dadurch gekennzeichnet, dass** der Wasserstoffgehalt im ersten und im zweiten transparenten leitfähigen Film eine Größenordnung von 10²¹ Atomen/cm² beträgt.

4. Solarzelle nach Anspruch 1, **dadurch gekennzeichnet, dass**:
das Substrat monokristallines Silizium umfasst, wobei die Hauptfläche und die anderen Hauptflächen texturiert sind und wobei
die p-Typ-Halbleiterschicht (4) eine amorphe p-Typ-Siliziumschicht umfasst und die n-Typ-Halbleiterschicht eine amorphe n-Typ-Siliziumschicht umfasst.

5. Solarzellenmodul, **dadurch gekennzeichnet, dass** es eine oder mehrere Solarzellen nach einem der Ansprüche 1 bis 4 aufweist.

6. Solarzellensystem, **dadurch gekennzeichnet, dass** es eine oder mehrere Solarzellen nach einem der Ansprüche 1 bis 4 aufweist.

## Revendications

1. Cellule solaire **caractérisée par**
un substrat semi-conducteur cristallin comprenant un matériau de type p ou de type n ;
une couche semi-conductrice de type p (4) formée sur une surface principale du substrat ; et
une couche semi-conductrice de type n (8) formée sur l'autre surface principale du substrat ;
dans laquelle un premier film conducteur transparent (5) comprenant de l'oxyde d'indium contenant de l'hydrogène et du cérium est formé sur la couche semi-conductrice de type p ; et
un deuxième film conducteur transparent (9) comprenant de l'oxyde d'indium ne contenant pas de cérium est formé sur la couche semi-conductrice de type n.

2. Cellule solaire selon la revendication 1, **caractérisée en ce que** le deuxième film conducteur transparent (9) contient de l'hydrogène et du tungstène.

3. Cellule solaire selon la revendication 1, **caractérisée en ce que** la teneur en hydrogène est de l'ordre de 10²¹ atomes/cm³ dans les premier et deuxième films conducteurs transparents.

4. Cellule solaire selon la revendication 1, **caractérisée en ce que**
le substrat comprend du silicium monocristallin, dans laquelle
la surface principale et les autres surfaces principales sont texturées, et en outre dans laquelle
la couche semi-conductrice de type p (4) comprend une couche de silicium amorphe de type p et la couche semi-conductrice de type n (8) comprend une couche de silicium amorphe de type n.

5. Module de cellule solaire, **caractérisé en ce qu'**il comporte une ou plusieurs cellules solaires selon l'une quelconque des revendications 1 à 4.

6. Système de cellule solaire, **caractérisé en ce qu'**il comporte un ou plusieurs modules de cellule solaire selon la revendication 5.
